# EUROPEAN PATENT APPLICATION

(11) **EP 1 617 488 A1**
(43) Date of publication of application: **18.01.2006**
(21) Application number: 04016323.0
(22) Date of filing: 12.07.2004
(51) Int. Cl.: H01L 33/00

(54) **Light emitting diode with improved heat dissipation and its manufacturing method**

(71) Applicant: NAN YA PLASTICS CORPORATION, Taipei (TW)
(72) Inventor: Shieh, Sung-Yueh, Taipei (TW); Fung, Dein-Run, Taipei (TW); Chang, Chi-Ming, Taipei (TW); Yang, Ming-Fa, Taipei (TW)
(74) Representative: Helms, Joachim

(57) **Abstract**

A LED device with high heat dissipation capability has heat dissipating package formed by transparent epoxy and heat dissipating packing epoxy which is a mixture of heat dissipating particles and packing epoxy; during packing process the upper light emitting portion of the LED device is firstly packed with transparent packing epoxy which will not influence the illumination function of the LED device, and then the lower heat dissipating portion of the LED device is packed with heat dissipating packing epoxy through which the heat generated by the LED device may be dissipated to the ambient air when the LED device is lit by high electric current, so that the LED device of this invention may greatly improve the heat accumulation problem and increase light emission efficiency when it is lit. Besides, since the production method disclosed in the invention is suitable for the production of the frame type LED device, the process and equipment for producing the conventional frame type LED device can be directly employed for mass production of the high heat dissipation LED device of the invention without further modification. The only thing need to do is to carry out one more time of filling the casting mold with heat dissipation packing epoxy under the same production condition.

## Description

### BACKGROUND OF THE PRESENT INVENTION

### 1. Field of the Present Invention

The invention relates to a high heat dissipation LED device and its manufacturing method, more particularly to a kind of LED device with packing epoxy mixed with heat dissipating particles capably to improve the heat accumulation problem and increase light emission efficiency.

### 2. Description of Prior Act

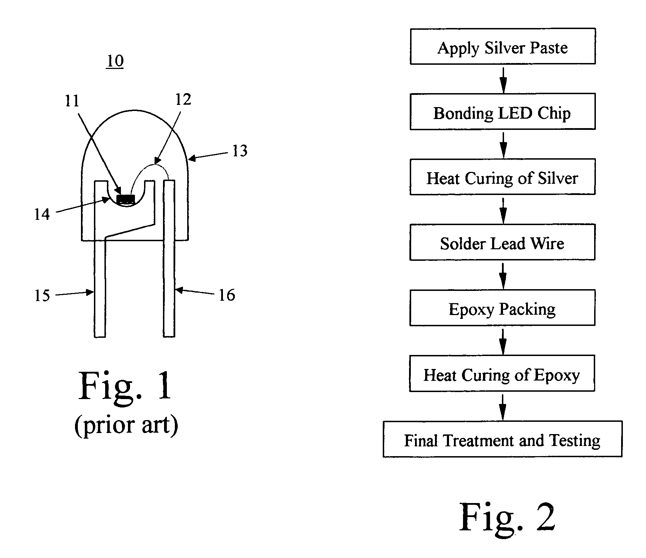

The structure of the conventional frame type LED device10 is shown in Fig. 1 which comprises a LED chip 11 installed in the reflecting bowl 14, a metal lead wire 12 connected to the LED chip 11 and the lead frame 16, and the transparent packing epoxy 13 which packs the whole structure into a complete unit of frame type LED device 10. When electric current passes through the lead frame 15, 16 and lead wire 12, the LED chip 11 is activated to emit light and enable illumination effect.

However owing to the poor heat conduction property of the transparent package epoxy 13 of the conventional frame type LED device 10, this type of LED device or LED assembly is always bothered by heat dissipation problem which results in the problem of poor heat dissipation and the problem of overheat that in turn causes heat accumulation on LED chip 11 of the conventional frame type LED device and gradually decreases light emission intensity though the increased electric current and heat accumulation increase the bandwidth of the exciting light emitted by the LED device. Therefore, in practical application, due to the aforesaid drawback the conventional frame type LED device 10 is inappropriate for being driven by high electric current, but only appropriate for being driven by low electric current (about 20mA) that results in the low unit light emission intensity of the conventional frame type LED device and the limited practical application.

Although several modified structures of LED device have been proposed in order to improve the heat dissipation problem of the conventional LED device such as the non-epoxy package type, ceramic heat dissipation type or metal plate heat dissipation type etc., but the production of these types of LED device requires modification in the package method of the conventional frame type LED device 10, in addition, the most part of the production process and package material must be changed, and new machine equipment special for each of these new LED structure must be designed and developed that will unavoidably increase production cost but decrease the rate of good product produced, and greatly increase the production time that will eventually and largely raise the selling price, and badly affect its applicability.

### SUMMARY OF THE PRESENT INVENTION

The major purpose of the present invention is to disclose a high heat dissipation LED device and its manufacturing method, especially a high heat dissipation frame type LED device which can improve the problem of poor heat dissipation of the conventional frame type LED device 10 or its assembly without modification of the production process, change of raw material and the related machine equipment for producing the conventional frame type LED device 10 to enable high heat dissipation capability, increased light emission efficiency as well as reduced production cost of the frame type LED device.

The minor purpose of the invention is to disclose a high heat dissipation frame type LED device and its manufacturing method of which the package comprises two layers of transparent epoxy package and heat dissipating epoxy package, and the heat dissipation epoxy is obtained by mixing the heat dissipating particles (such as AlN, BN, ZnO, SiO₂, CaCO₃, MgO, CeO₂ and MoO₃ etc.) with the packing epoxy. When the LED is packed, the upper light emitting portion is firstly packed with transparent epoxy which will not influence the illumination effect of the LED device, and then the lower heat dissipating portion of the LED device is packed with the heat dissipating packing epoxy through which the heat generated by the LED can be dissipated to the ambient air, that the heat accumulation problem of the LED driven by high electric current can be greatly improved, and the light emission efficiency can be largely increased.

### BRIEF DESCRIPTION OF THE DRAWING FIGURES

Fig. 1 is the schematic drawing of the structure of conventional frame type LED device 10.
Fig. 2 is the flow diagram showing the production process of the conventional frame type LED device 10.
Fig. 3 is the schematic drawing of the structure of high heat dissipation frame type LED device 20 of the invention.
Fig. 4 is the flow diagram showing the production process of the high heat dissipation frame type LED device 20 of the invention.

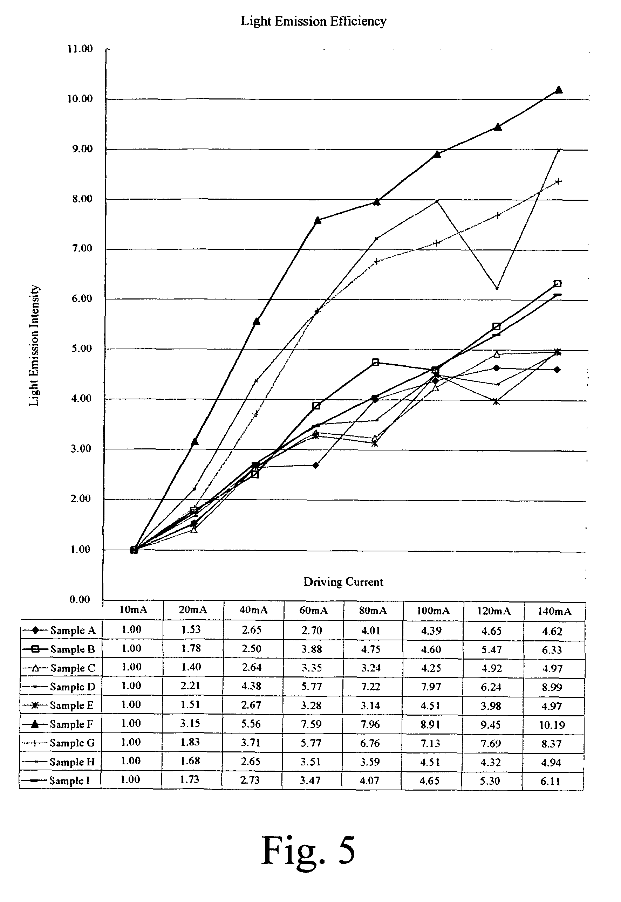

Fig. 5 is the comparison of light emission efficiency showing the light emission intensity data recorded from example 1 of the embodiment of frame type blue LED of the invention including sample B through sample I containing different kinds and proportions of heat dissipating particles 25 and sample A of conventional frame type blue LED for comparison purpose. These LEDs were driven by electric current of 10mA, 20mA, 40mA, 60mA, 80mA, 100mA, 120mA and 140mA. The horizontal axis represents Driving Current, and the vertical axis represents Light Emission Efficiency of which the light emission intensity obtained by using driving current of 10mA is defined as 1 unit intensity.

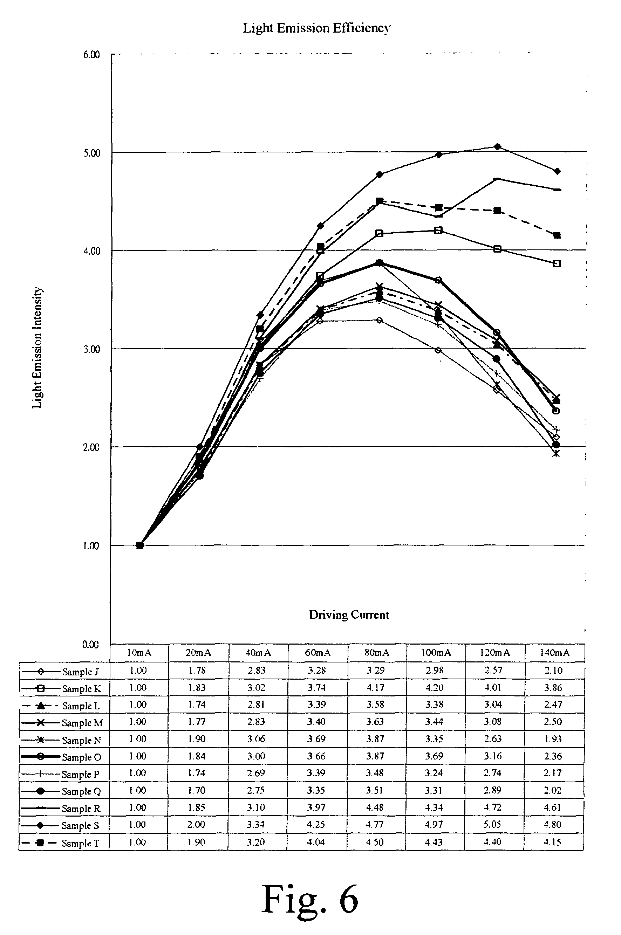

Fig. 6 is the comparison of light emission efficiency showing the light emission intensity data recorded from example 2 of the embodiment of frame type white LED of the invention including sample K through sample T containing different kinds and proportions of heat dissipation particles (25) and sample J of conventional frame type white LED for comparison purpose. These LEDs were driven by electric current of 10mA, 20mA, 40mA, 60mA, 80mA, 100mA, 120mA and 140mA. The horizontal axis represents Driving current, and the vertical axis represents Light emission efficiency of which the light emission intensity obtained by using driving current of 10mA is defined as 1 unit intensity.

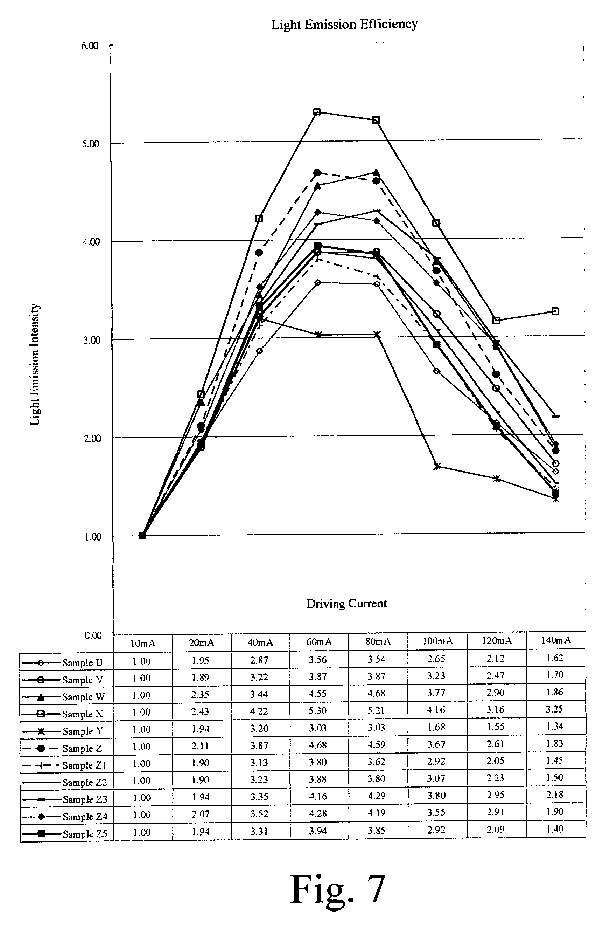

Fig. 7 is the comparison of light emission efficiency showing the light emission intensity data recorded from examples 3 of the embodiment of the frame type red LED of the invention including sample V through sample Z5 and sample U of conventional frame type red LED for comparison purpose. These LEDs were driven by electric current of 10mA, 20mA, 40mA, 60mA, 80mA, 100mA, 120mA and 140mA. The horizontal axis represents Driving current, and the vertical axis represents Light emission intensity of which the light emission intensity obtained by using driving current of 10mA is defined as 1 unit intensity.

### DETAILED DESCRITION OF THE PREFERRED EMBODIMENTS

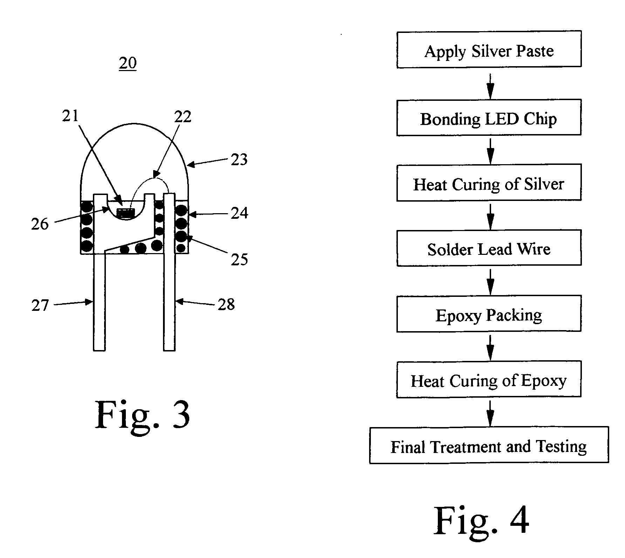

The major purpose of the invention is to provide a high heat dissipation LED device 20 as shown in Figure 3 which may improve the heat accumulation problem of LED without influence to the production process, raw material and related machine equipment used for producing the conventional frame type LED device 10.

Referring to Fig. 1 and Fig. 2, the production process for producing the conventional frame type LED (10) includes the following steps:
a. Apply silver paste:
   Apply silver paste on the surface of the reflecting bowl 14 for bonding the LED chip;
b. Install the LED chip:
   Place the LED chip 11 on the silver paste in the reflecting bowl 14;
c. Heat curing:
   Harden the silver paste by backing;
d. Solder the lead wire:
   Connect the lead wire 12 to the metal pad on LED chip 11 and lead frame 16 by means of soldering to form electrical connection through which the electric current will activate the LED chip 11 to emit light.
e. Packing:
   Fill the casting mold with packing epoxy to form the desired shape of the frame type LED device 10.
f. Heat curing:
   Harden the packing epoxy 13 by baking.
g. Final treatment and testing:
   After completing the epoxy packing process the leads of the frame type LED 10 are cut and bended into the desired size and shape according to the requirement of customers, and then the final product is tested and packed according to the required specification.

As illustrated in Figure 3 the high heat dissipation LED device (20) is mainly in frame type LED structure including such as two-lead vertical type Lamp LED device with two leads in vertical and parallel position or multiple-lead Power LED etc. which comprises a metal lead wire (22) connected to the LED chip (21) and lead frame (28). The upper light emitting portion of the high heat dissipation LED device (20) is packed with transparent epoxy to form the transparent epoxy layer 23, and the lower heat dissipating portion of the high heat dissipation LED device (20) is packed with heat dissipating epoxy which is a mixture of heat dissipating particles (25) and packing epoxy to form the heat dissipating epoxy layer (24); when electric current passes through the lead (27) and lead wire (22), the LED chip (21) is activated to emit light, in addition, the heat generated by the LED chip (21) can be conducted by the heat dissipating epoxy layer (24), and dissipated into the ambient air that can prevent the LED chip (21) from overheat, and increase light emission efficiency of the high heat dissipation LED device (20).

As shown in Figure 4 is the production process of the high heat dissipation LED device (20) of the invention which comprises the follow steps:
a. Apply silver paste:
   Apply silver paste on the central position of the reflecting bowl (26) for bonding the LED chip;
b. Install LED chip:
   Place the LED chip (21) on the silver paste in the reflecting bowl;
c. Heat curing:
   Harden the silver paste by baking;
d. Solder the metal lead wire:
   Connect the metal lead wire (22) to the metal pad on the LED chip (21) and lead frame (28) by means of soldering to form electrical connection through which the LED chip (21) can be activated to emit light when electric current passes through the lead (27) and lead wire 22;
e. First step epoxy packing:
   Fill the casting mold of the high heat dissipation LED device (20) with transparent epoxy to form the transparent epoxy layer (23) to a level up to approximately half of the depth of the reflecting bowl (depending on the size of the lead frame and shape of the mold) as shown in Figure 3. The purpose of the epoxy packing in this stage is to maintain an unaffected light emitting function of the LED (21).
f. Heat curing of first step epoxy package:
   Dry and harden the first stage transparent epoxy layer (23) by baking; or use ultra violet light to harden the epoxy;
g. Second step epoxy packing:
   Fill the remaining space of the casting mold with heat dissipating epoxy to form the lower heat dissipating portion of the high heat dissipation LED device (20) to construct the heat dissipating epoxy layer (24) as shown in Figure 3; The purpose of the packing in this stage is to enable heat conduction through the heat dissipating particles (25) in the heat dissipating epoxy layer (24) to dissipate the heat energy generated by the LED chip (21) when it is driven by electric current to emit light that can increase the service life and light emitting efficiency of the frame type LED device (20); multiple times of packing may be made whenever required;
h. Heat caring of second step epoxy package:
   Dry and harden the second stage heat dissipating epoxy package by baking or use ultra violet light to harden the epoxy.
      i. Final treatment and testing:
         After completing the epoxy packing work the leads are cut and bended into the desired size and shape according to the requirements of customers, and then the finished high heat dissipation LED device (21) is tested and packed according to the required specification.

From the comparison of the above-mentioned production process for the conventional frame type LED device 10 and the high heat dissipation LED device 20 it is obvious that the production process of the invention does not interfere with the production process, raw material and the machine equipment used for producing the conventional frame type LED device 10, the only thing need to do is to carry out one more time of filling the casting mold with heat dissipating epoxy to form heat dissipating epoxy layer 24 which can increase the heat dissipation capability of LED device and enable better light emitting efficiency when the high heat dissipation LED device 20 is lit under high electric current, and the influence on production cost is quite little as compared with that of the conventional LED device.

### PREFERRED EMBODIMENT OF THE INVENTION

The heat dissipating particle 25 is made of single material or a blend of particles made of different materials selected from the material group of AlN, BN, ZnO, SiO₂, CaCO₃, MgO, CeO₂ and MoO₃. The heat dissipating particle 25 shall be in a size ranged from 500 µm to 5 nm; and in shape of ball, needle or in irregular shape; the heat dissipating particle 25 shall be made up a ratio ranged from 1% to 70% to the total weight of the heat dissipating epoxy layer 24 of the high heat dissipation frame type LED device 20. The proportion can be adjusted to the optimal condition according to the heat conduction capability of the heat dissipating particle 25, the heat dissipation requirement of the high heat dissipation LED device 20 in practical operation and the property of the epoxy.

In the following are the examples of embodiment of the high heat dissipation LED device 20 made by using the method disclosed in the present invention which has the heat dissipating epoxy layer 24 formed by blending the heat dissipating particle 25 with packing epoxy.

### Example 1

In this example the high heat dissipation LED 20 which may emit blue light was employed.

The structure of the lead frame of the LED has two leads in parallel and vertical direction 27, 28. The LED chip (21) was GaN blue LED chip.

The heat dissipating particle 25 of the heat dissipating epoxy layer 24 was selected from the samples from B to I as shown in table 1

While sample A was selected as a comparative example which had only one transparent epoxy layer 23 without heat dissipating epoxy layer 24, i.e. the conventional LED device.

Both of these two types of LED device were driven by the electric current of 10mA, 20mA, 40mA, 60mA, 80mA, 100mA, 120mA and 140mA respectively to emit blue light, and the light emission intensity data were recorded with the light emission intensity under the driving electric current of 10mA defined as 1 unit.

The comparison of the light emitting efficiency between the high heat dissipation LED device 20 and the conventional LED device which is without heat dissipating epoxy layer 24 is shown in Fig. 5.

**Table 1**

| Heat Dissipating Epoxy Layer | Selected Heat Dissipating particle | Proportion of heat dissipating particle |
|---|---|---|
| Sample A | -- | 0 |
| Sample B | AlN | 20% |
| Sample C | CaCO₃(1) | 20% |
| Sample D | CaCO₃(2) | 20% |
| Sample E | SiO₂ | 20% |
| Sample F | ZnO (1) | 20% |
| Sample G | ZnO (2) | 20% |
| Sample H | ZnO (3) | 20% |
| Sample I | MoO₃ | 20% |

From Table 1 it shows that the light emission intensity of the high heat dissipation LED device 20 varies approximately linearly with respect to the variation of the driving electric current. The increase of driving electric current caused an apparent increase of light emission intensity.

Whereas, as for the LED device of sample A which has conventional package the light emission intensity didn't increase apparently following the increase of its driving electric current. It was due to overheat of the LED caused by heat accumulation that severely affected its light emitting efficiency. Among the samples from B to I, the sample F which had ZnO as the heat dissipating particle 25 had the highest dissipating efficiency, and presented a light emitting efficiency at driving electric current of 140 mA approximately two times as high as that of the LED device having conventional package under the same condition.

### Example 2

In this example the high heat dissipation LED device 20 which may emit white light was employed.

The LED chip 21 was GaN blue LED chip installed in the reflecting bowl 26 which was filled with yellow phosphor. The structure of the lead frame was two leads in parallel and vertical direction 27, 28.

The heat dissipating particle 25 of the heat dissipating epoxy layer 24 was selected from the samples from K to T as shown in Table 2.

While sample J was selected as a comparative example which had only one transparent epoxy layer 23 without heat dissipating epoxy layer 24, i.e. the conventional LED device.

Both of these two types of LED device were driven by the electric current of 10mA, 20mA, 40mA, 60mA, 80mA, 100mA, 120mA and 140mA respectively to emit white light, and the light emission intensity data were recorded with the light emission intensity under the driving electric current of 10mA defined as 1 unit.

The comparison of the light emission intensity between the high heat dissipation LED device 20 and the conventional LED device which is without heat dissipating epoxy layer is shown in Fig. 6.

**Table 2**

| Heat Dissipating Epoxy Layer | Selected Heat Dissipating particle | Proportion of heat dissipating particle |
|---|---|---|
| Sample J | -- | 0 |
| Sample K | AlN | 20% |
| Sample L | CaCO₃(1) in nm size | 20% |
| Sample M | CaCO₃(2) in nm size | 20% |
| Sample N | SiO₂ in nm size | 20% |
| Sample O | ZnO (1) | 20% |
| Sample P | ZnO (2) | 20% |
| Sample Q | ZnO (3) | 20% |
| Sample R | AlN | 40% |
| Sample S | BN | 20% |
| Sample T | MoO₃ | 20% |

From Table 2 it shows that the light emitting efficiency of the high heat dissipation LED device 20 increased following an increase of the proportion of the heat dissipating particle 25 made up of the total weight of the heat dissipating epoxy. Among the samples from K to T, the sample R which had heat dissipating particles of A1N made up 40% of the total weight of the heat dissipating epoxy layer 24 presented a light emitting efficiency at driving electric current of 140mA approximately twice as high as that of the conventional LED device having conventional package under the same condition.

### Example 3

In this example the high heat dissipation LED device 20 which may emit red light was employed.

The LED chip 21 was 4-element red LED chip. The structure of the lead frame was two leads in parallel and vertical direction 27, 28.

The heat dissipating particle 25 of the heat dissipating epoxy layer 24 was selected from the samples from V to Z5 as shown in table 3.

While sample U is selected as a comparative example which had only one transparent epoxy layer 23 without heat dissipating epoxy layer 24, i.e. the conventional LED device.

Both of these two types of LED device were driven by the electric driving current of 10mA, 20mA, 40mA, 60mA, 80mA, 100mA, 120mA, and 140mA respectively to emit red light, and the light emission intensity data were recorded with the light emission intensity under the driving electric current of 10mA defined as 1 unit.

The comparison of the light emission intensity between the high heat dissipation LED device 20 and the conventional LED device which is without heat dissipating epoxy layer is shown in Fig. 7.

**Table 3**

| Heat Dissipating Epoxy Layer | Selected Heat Dissipating particle | Proportion of heat dissipating particle |
|---|---|---|
| Sample U | -- | 0 |
| Sample V | AlN | 20% |
| Sample W | CaCO₃(1) in nm size | 20% |
| Sample X | CaCO₃(2) in nm size | 20% |
| Sample Y | SiO₂ in nm size | 20% |
| Sample Z | ZnO (1) | 20% |
| Sample Z 1 | ZnO (2) | 20% |
| Sample Z2 | ZnO (3) | 20% |
| Sample Z3 | AlN | 40% |
| Sample Z4 | BN | 20% |
| Sample Z5 | MoO₃ | 20% |

From Table 3 it shows that sample X which had heat dissipating particle of CaCO₃(2) in nanometer size made up 20% of the total weight of the heat dissipating epoxy layer 24 presented a light emitting efficiency at driving electric current of 140mA approximately twice as high as that of the conventional LED device under the same condition.

From the above-mentioned description it shows that the high heat dissipation LED device 20 of the invention may apparently improve the heat dissipation problem suffered by the conventional frame type LED device or its assembly, increase its service life and light emitting efficiency without modification or change of the production process, raw material and the related machine equipment for the conventional frame type LED device that may provide significant advantage in the application, popularization and future development of the frame type LED device.

## Claims

1. A high heat dissipation LED device having an upper light emitting portion formed by transparent packing epoxy and a lower heat dissipating portion formed by heat dissipating epoxy which is a blend of heat dissipating particles and packing epoxy.

2. The high heat dissipation LED device as defined in claim 1, wherein the heat dissipating particles are made of the material selected from one or more than one of the materials of AlN, BN, ZnO, SiO₂, CaCO₃, MgO, CeO₂ and MoO₃.

3. The high heat dissipation LED device as defined in claim 1 or claim 2,
wherein the heat dissipating particles made up a proportion ranged from 1% to 70% to the total weight of the heat dissipating epoxy.

4. The high heat dissipation LED device as defined in claim 3, wherein the size of the heat dissipating particle is in the range from 500µm to 5nm.

5. The high heat dissipation LED device as defined in claim 4 wherein the heat dissipating particle is in ball shape or needle shape.

6. The high heat dissipation LED device as defined in any of claim 1 to claim 5,
wherein the LED device is lamp LED with two parallel and vertical leads.

7. The high heat dissipation LED device as defined in any of claim 1 to claim 5,
wherein the LED device is power LED with multiple leads.

8. A method for manufacturing the high heat dissipation LED device comprising the following steps:
(a) apply silver paste:
applying silver paste on the center position in reflecting bowl for bonding LED chip;
(b) bonding LED chip:
placing LED chip on the silver paste located on the center position in reflecting bowl as describe in step (a);
(c) heat curing :
harden the silver paste by baking;
(d) Solder the lead wire:
connecting the lead wire to the LED chip installed in step (b) and the lead frame of the LED device by means of soldering to form electrical connection;
(e) first step epoxy packing:
filling the casting mold of the LED device with transparent epoxy to a level half of the depth of the reflecting bowl to form the upper light emitting portion;
(f) first step epoxy package curing:
harden the upper light emitting portion finished in step (e) by baking process or by ultra violet light curing process;
(g) second step epoxy packing:
filling the remaining space of the casting mold of the LED device with heat dissipating epoxy obtained by blending heat dissipating particles and packing epoxy; and
(h) second step epoxy package curing:
harden the lower heat dissipating portion finished in step (g) by baking process or by ultra violet light curing process.

9. The manufacturing method as defined in claim 8, wherein the LED chip is one of the LED chips of white, UV, violet, blue green, yellow, and orange LED.

10. The manufacturing method as defined in claim 8, wherein the heat dissipating particle used in step (g) is made of one or more than one of the materials of AlN, BN, ZnO, SiO₂, CaCO₃, MgO, CeO₂ and MoO₃.

11. The manufacturing method as defined in claim 8, claim 9 or claim 10, wherein the manufacturing method is used for producing Lamp LED device with two leads in vertical and parallel position.

12. The manufacturing method as defined in claim 8, claim 9 or claim 10, wherein the manufacturing method is used for producing Lamp LED device with multiple leads.
